# EUROPEAN PATENT APPLICATION

(11) **EP 4 729 968 A1**
(43) Date of publication of application: **22.04.2026**
(21) Application number: 25745257.3
(22) Date of filing: 24.01.2025
(51) Int. Cl.: G01R 31/392, G01R 31/396, G01R 31/382, B60L 58/10

(54) **APPARATUS AND METHOD FOR GENERATING BATTERY INFORMATION**

(30) Priority: 26.01.2024 KR 20240012534
(71) Applicant: LG Energy Solution, Ltd., Seoul 07335 (KR)
(72) Inventor: CHOI, Soon-Hyung, Daejeon 34122 (KR); KIM, Young-Deok, Daejeon 34122 (KR)
(74) Representative: Goddar, Heinz J.
(86) International application number: PCT/KR2025/001527
(87) International publication number: WO 2025/159591

(57) **Abstract**

A battery information generating apparatus according to an embodiment of the present disclosure includes: a profile acquisition unit that acquires a battery profile representing a correspondence between a capacity and a voltage of a battery; and a control unit that sets a positive electrode section and a negative electrode section that correspond to the battery, based on preset section information for each degradation level, and adjusts a preset reference positive electrode profile and a preset reference negative electrode profile to correspond to the battery profile within the positive electrode section and the negative electrode section, to generate a positive electrode profile and a negative electrode profile of the battery.

## Description

### TECHNICAL FIELD

This application is based on and claims priority from Korean Patent Application No. 10-2024-0012534, filed on January 26, 2024, with the Korean Intellectual Property Office, the disclosure of which is incorporated herein in its entirety by reference.

The present disclosure relates to a battery information generating apparatus and method, more particularly, an apparatus and method for generating battery information more accurately reflecting the state of a battery.

### BACKGROUND

Recently, as the demand for portable electronic products such as notebook computers, video cameras, and portable telephones has rapidly increased, and as the development of electric vehicles, energy storage batteries, robots, and satellites has begun in earnest, researches on the high-performance batteries allowing repeated charging and discharging are being actively conducted.

Currently, commercially available batteries include, for example, nickelcadmium batteries, nickel-hydrogen batteries, nickel-zinc batteries, and lithium batteries. Of these batteries, lithium batteries are gaining considerable attention due to their advantages including a substantially low memory effect to allow a high degree of freedom in charging and discharging, a very low self-discharging rate, and high energy density, as compared to nickel-based batteries.

While many studies are being conducted on the batteries focusing on the high-capacity and the high-density, it is also important to improve the lifespan and the safety of the batteries. In order to enhance the safety of batteries, a technology is necessary, which may accurately diagnose the current state of batteries.

### DISCLOSURE

### TECHNICAL PROBLEM

The present disclosure provides a battery information generating apparatus and method, which may generate a more accurate profile used to diagnose the state of a battery.

Various aspects of the present disclosure may be understood from the descriptions herein below, and may be more clearly understood from embodiments of the present disclosure. Further, it is readily apparent that various aspects of the present disclosure may be implemented by elements described in the claims and combinations thereof.

### Technical Solution

A battery information generating apparatus according to an aspect of the present disclosure may include: a profile acquisition unit that acquires a battery profile representing a correspondence between a capacity and a voltage of a battery; and a control unit that sets a positive electrode section and a negative electrode section that correspond to the battery, based on preset section information for each degradation level, and adjusts a preset reference positive electrode profile and a preset reference negative electrode profile to correspond to the battery profile within the positive electrode section and the negative electrode section, to generate a positive electrode profile and a negative electrode profile of the battery.

The positive electrode section may be set to a section including voltages or capacities of a start point and an end point of the positive electrode profile.

The negative electrode section may be set to a section including voltages or capacities of a start point and an end point of the negative electrode profile.

The section information for each degradation level may be preset to include section information in accordance with a degradation level of the battery.

Based on the section information for each degradation level, the control unit may be configured to set the positive electrode section and the negative electrode section that correspond to the degradation level of the battery.

The section information for each degradation level may be preset to include section information for each of a plurality of cycles in accordance with a degradation level relative to a previous cycle.

Based on the section information for each degradation level, the control unit may be configured to set the positive electrode section and the negative electrode section that correspond to the cycle and the degradation level of the battery.

The section information for each degradation level may be preset to include section information for each of a plurality of cycles in accordance with a degradation type and a degradation level relative to a previous cycle.

Based on the section information for each degradation level, the control unit may be configured to set the positive electrode section and the negative electrode section that correspond to the cycle, the degradation type, and the degradation level of the battery.

The control unit may be configured to estimate a degradation level of the battery based on a capacity of the battery and a preset initial capacity.

The control unit may be configured to output the positive electrode profile and the negative electrode profile to an outside, to provide information about the battery.

A battery pack according to another aspect of the present disclosure may include the battery information generating apparatus according to an aspect of the present disclosure.

A vehicle according to yet another aspect of the present disclosure may include the battery information generating apparatus according to an aspect of the present disclosure.

A battery information generating method according to still yet another aspect of the present disclosure may include: a profile acquisition step of acquiring a battery profile representing a correspondence between a capacity and a voltage of a battery; a section setting step of setting a positive electrode section and a negative electrode section that correspond to the battery, based on preset section information for each degradation level; and a profile generation step of adjusting a preset reference positive electrode profile and a preset reference negative electrode profile to correspond to the battery profile within the positive electrode section and the negative electrode section, to generate a positive electrode profile and a negative electrode profile of the battery.

The section information for each degradation level may be preset to include section information in accordance with a degradation level of the battery, and based on the section information for each degradation level, the section setting step may set the positive electrode section and the negative electrode section that correspond to the degradation level of the battery.

The section information for each degradation level may be preset to include section information for each of a plurality of cycles in accordance with a degradation level relative to a previous cycle, and based on the section information for each degradation level, the section setting step may set the positive electrode section and the negative electrode section that correspond to the cycle and the degradation level of the battery.

The section information for each degradation level may be preset to include section information for each of a plurality of cycles in accordance with a degradation type and a degradation level relative to a previous cycle, and based on the section information for each degradation level, the section setting step sets the positive electrode section and the negative electrode section that correspond to the cycle, the degradation type, and the degradation level of the battery.

The battery information generating method according to still yet another aspect of the present disclosure may further include a degradation estimation step of estimating a degradation level of the battery based on a capacity of the battery and a preset initial capacity.

The battery information generating method according to still yet another aspect of the present disclosure may further include an information providing step of outputting the positive electrode profile and the negative electrode profile to an outside, to provide information about the battery.

A non-transitory computer-readable storage medium according to still yet another aspect of the present disclosure may store a program for performing a battery information generating method including: a profile acquisition step of acquiring a battery profile representing a correspondence between a capacity and a voltage of a battery; a section setting step of setting a positive electrode section and a negative electrode section that correspond to the battery, based on preset section information for each degradation level; and a profile generation step of adjusting a preset reference positive electrode profile and a preset reference negative electrode profile to correspond to the battery profile within the positive electrode section and the negative electrode section, to generate a positive electrode profile and a negative electrode profile of the battery.

### Advantageous Effects

According to an aspect of the present disclosure, the battery information generating apparatus may accurately estimate a positive electrode profile and a negative electrode profile that correspond to the state of a battery, taking into account the degradation level of a battery.

The effects of the present disclosure are not limited to those described above, and other effects that are not described herein may clearly be understood to those skilled in the art from the descriptions in the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery information generating apparatus according to an embodiment of the present disclosure.
FIG. 2 is a view schematically illustrating a first table representing section information for each degradation level according to an embodiment of the present disclosure.
FIG. 3 is a view schematically illustrating a positive electrode profile and a negative electrode profile of a battery according to an embodiment of the present disclosure.
FIG. 4 is a view schematically illustrating a second table representing section information for each degradation level according to an embodiment of the present disclosure.
FIG. 5 is a view schematically illustrating a third table representing section information for each degradation level according to an embodiment of the present disclosure.
FIG. 6 is a graph referred-to for describing an example of each of a reference positive electrode profile and a reference negative electrode profile.
FIG. 7 is a graph referred-to for describing an example of a measured full-cell profile of a target cell.
FIGS. 8 to 10 are views referred-to for describing an example of a procedure for generating a comparative full-cell profile used for a comparison with the measured full-cell profile according to an embodiment of the present disclosure.
FIGS. 11 to 13 are views referred-to for describing another example of the procedure for generating the comparative full-cell profile used for a comparison with the measured full-cell profile according to an embodiment of the present disclosure.
FIG. 14 is a view schematically illustrating a battery pack according to another embodiment of the present disclosure.
FIG. 15 is a view schematically illustrating a vehicle according to yet another embodiment of the present disclosure.
FIG. 16 is a view schematically illustrating a battery information generating method according to still yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Accordingly, it can be appreciated that the embodiments described herein and the configurations illustrated in the drawings are merely examples of the present disclosure, which do not exhaustively represent the technical idea of the present disclosure, and various equivalents and modifications may be made to substitute the present disclosure at the time of filing the present disclosure.

When describing the present disclosure, detailed description of related known configurations or functions may be omitted if determined to obscure the gist of the present disclosure.

Terms with ordinal numbers such as first, second and so on may be used to discriminate one of various components from the other, but should not be interpreted as limiting the components.

Throughout the descriptions herein, when a certain part "includes" a specific component, this description does not indicate that the certain part excludes other components, but indicates that the certain part may further include other components, unless otherwise defined.

Further, throughout the descriptions herein, when two components are "connected" to each other, this description indicates not only that the two components are "directly connected" to each other, but also that the two components are "indirectly connected" to each other via another component.

Hereinafter, embodiments of the present disclosure will be described in detail with reference to the accompanying drawings.

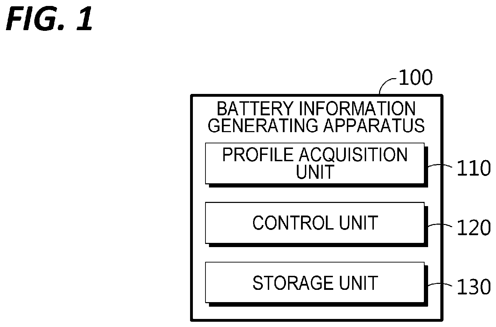

FIG. 1 is a view schematically illustrating a battery information generating apparatus 100 according to an embodiment of the present disclosure.

Referring to FIG. 1, the battery information generating apparatus 100 may include a profile acquisition unit 110, a control unit 120, and a storage unit 130.

Here, a battery subjected to information generation indicates a single isolated cell that is physically separable, and has a negative electrode terminal and a positive electrode terminal. For example, a lithium-ion battery or a lithium polymer battery may be considered as the battery. The type of battery may be a cylindrical type, a prismatic type, or a pouch type. Further, the battery may indicate a battery bank, a battery module, or a battery pack, in which a plurality of cells is connected to each other in series and/or in parallel. Hereinafter, for the convenience of description, descriptions are made assuming that the battery indicates a single isolated cell.

The profile acquisition unit 110 may be configured to acquire a battery profile representing a correspondence between the capacity and the voltage of a battery.

For example, the battery profile represents a correspondence between the voltage (V) and the capacity (Q) of a battery when the battery is charged from a preset charging start SOC or 0 % to a preset charging termination SOC or 100 %. In another example, the battery profile may represent a correspondence between the voltage (V) and the capacity (Q) of a battery when the battery is discharged from a preset discharging start SOC or 100 % to a preset discharging termination SOC or 0 %.

For example, the C-rate of the charging or discharging for generating the battery profile is not particularly limited. However, in order to acquire a more accurate battery profile, the battery needs to be charged or discharged at a low rate. For example, the battery profile may be generated during the process of charging or discharging the battery at 0.05 C.

In an example, the profile acquisition unit 110 may directly read or receive a battery profile BP of the battery from the outside. For example, the profile acquisition unit 110 may acquire the battery profile by being connected to the outside via a wired and/or wireless network to read or receive the battery profile.

In another example, the profile acquisition unit 110 may generate the battery profile based on battery information about the voltage and the capacity of the battery. For example, the profile acquisition unit 110 may acquire the battery profile by directly generating the battery profile based on the battery information.

The profile acquisition unit 110 may be connected to the control unit 120 for a communication. For example, the profile acquisition unit 110 may be connected to the control unit 120 in the wired or wireless manner. In an example, the profile acquisition unit 110 may transmit the acquired battery profile to the control unit 120. In another example, the control unit 120 may read the battery profile from the profile acquisition unit 110.

The control unit 120 may be configured to set a positive electrode section and a negative electrode section corresponding to the battery based on preset section information for each degradation level.

For example, the control unit 120 may be configured to set the positive electrode section and the negative electrode section corresponding to the degradation level of the battery, based on the section information for each degradation level. For example, assuming that the degradation level of the battery is x %, the control unit 120 may determine the positive electrode section and the negative electrode section corresponding to the x % degradation level of the battery from the section information for each degradation level.

Here, the section information for each degradation level may be preset to include information about a positive electrode section and information about a negative electrode section, for each degradation level of the battery. The positive electrode section may be set to include voltages or capacities of a start point and an end point of a positive electrode profile. The negative electrode section may be set to include voltages or capacities of a start point and an end point of a negative electrode profile. Hereinafter, for the convenience of description, it is assumed that the positive electrode section specifies a voltage section of the positive electrode profile, and the negative electrode section specifies a voltage section of the negative electrode profile.

In an embodiment, the section information for each degradation level may be preset to include section information in accordance with the degradation level of the battery.

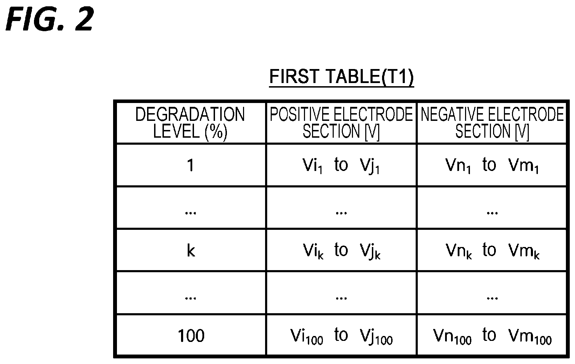

FIG. 2 is a view schematically illustrating a first table T1 representing the section information for each degradation level according to an embodiment of the present disclosure. The first table T1 of FIG. 2 represents an association relationship between the degradation level of the battery and the positive and negative electrode sections. For example, the first table T1 may include information about the positive electrode section and the negative electrode section set for each degradation level of the battery.

For example, in the embodiment of FIG. 2, when the degradation level of the battery is k %, the positive electrode section may be preset to Viₖ[V] to Vjₖ[V], and the negative electrode section may be preset to Vnₖ[V] to Vmₖ[V].

In an embodiment, the profile acquisition unit 110 may acquire the battery profile and the information about the degradation level of the battery together. For example, the battery profile and the information about the degradation level of the battery may be mapped with each other. For example, by acquiring a "battery profile of the battery with the x % degradation level," the profile acquisition unit 110 may acquire the information about the degradation level together with the battery profile. Then, the control unit 120 may read or receive the information about the degradation level of the battery from the profile acquisition unit 110.

In another embodiment, the control unit 120 may estimate the degradation level of the battery from the battery profile. For example, the control unit 120 may be configured to estimate the degradation level of the battery based on the capacity of the battery and a preset initial capacity.

For example, the battery profile may include the capacity of the battery measured from the charging start time point (or the discharging start time point) of the battery to the charging termination time point (or the discharging termination time point) of the battery. Thus, the control unit 120 may determine a target capacity of the battery from the battery profile.

Then, the control unit 120 may calculate a ratio of the target capacity of the battery to the preset initial capacity of the battery, to estimate the degradation level of the battery. Here, the initial capacity refers to an initial value of the capacity of the battery, and may be set based on an initial capacity of a battery in the beginning of life (BOL) state, a reference battery designed to conform to a battery, or a theoretically ideally designed battery.

For example, the control unit 120 may calculate the arithmetic formula of "1-(target capacity÷initial capacity)" or "{1-(target capacity÷initial capacity)}×100" to estimate the degradation level (%) of the battery relative to the initial capacity.

The control unit 120 may be configured to generate the positive electrode profile and the negative electrode profile of the battery by adjusting a preset reference positive electrode profile and a preset reference negative electrode profile to correspond to the battery profile within the positive electrode section and the negative electrode section.

The reference positive electrode profile may be a profile representing the correspondence between the capacity and the voltage of a reference positive electrode cell preset to correspond to the positive electrode of the battery. For example, the reference positive electrode cell may be a positive electrode coin half cell or the positive electrode of a three-electrode cell. The reference negative electrode profile may be a profile representing the correspondence between the capacity and the voltage of a reference negative electrode cell preset to correspond to the negative electrode of the battery. For example, the reference negative electrode cell may be a negative electrode coin half cell or the negative electrode of a three-electrode cell.

The control unit 120 may adjust the reference positive electrode profile and the reference negative electrode profile to correspond to the battery profile. For example, the control unit 120 may adjust the reference positive electrode profile and the reference negative electrode profile to generate an adjusted positive electrode profile and an adjusted negative electrode profile. Then, the control unit 120 may generate a comparative profile from the adjusted positive electrode profile and the adjusted negative electrode profile. The control unit 120 may adjust the reference positive electrode profile and the reference negative electrode profile until the comparative profile corresponds to the battery profile.

For example, the control unit 120 may shift the reference positive electrode profile and the reference negative electrode profile or perform a capacity scaling to generate a plurality of comparative profiles, and identify a comparative profile having a minimum error with the battery profile among the plurality of comparative profiles. Then, the control unit 120 may determine the adjusted positive electrode profile corresponding to the identified comparative profile to be the positive electrode profile of the battery. Then, the control unit 120 may determine the adjusted negative electrode profile corresponding to the identified comparative profile to be the negative electrode profile of the battery. For example, the adjusted positive electrode profile and the adjusted negative electrode profile that correspond to the identified comparative profile may be estimated as the positive electrode profile and the negative electrode profile of the battery, respectively.

Here, the voltage range of the adjusted positive electrode profile may be included in the set positive electrode section, and the voltage range of the adjusted negative electrode profile may be included in the set negative electrode section. For example, the control unit 120 may adjust the reference positive electrode profile and the reference negative electrode profile such that the voltages of a positive electrode activation initial point and a positive electrode activation final point of the adjusted positive electrode profile fall in in the positive electrode section, and the voltages of a negative electrode activation initial point and a negative electrode activation final point of the adjusted negative electrode profile fall in the negative electrode section.

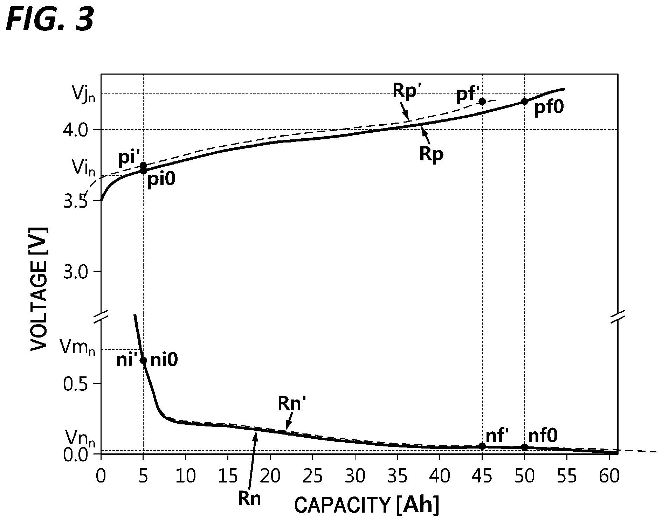

FIG. 3 is a view schematically illustrating the positive electrode profile and the negative electrode profile of the battery according to an embodiment of the present disclosure.

In the embodiment of FIG. 3, the control unit 120 may adjust a reference positive electrode profile Rp and a reference negative electrode profile Rn to generate an adjusted positive electrode profile Rp' and an adjusted negative electrode profile Rn'. For example, the adjusted positive electrode profile Rp' and the adjusted negative electrode profile Rn' are generated according to the cooperative relationship between the reference positive electrode profile Rp and the reference negative electrode profile Rn. Then, the control unit 120 may determine the adjusted positive electrode profile Rp' to be the positive electrode profile of the battery, and the adjusted negative electrode profile Rn' to be the negative electrode profile of the battery. The voltages of a positive electrode activation initial point pi' and a negative electrode activation final point pf of the adjusted positive electrode profile Rp' are included in the positive electrode section Viₙ to Vjₙ. The voltages of a negative electrode activation initial point ni' and a negative electrode activation final point nf' of the adjusted negative electrode profile Rn' are included in the negative electrode section Vnₙ to Vmₙ.

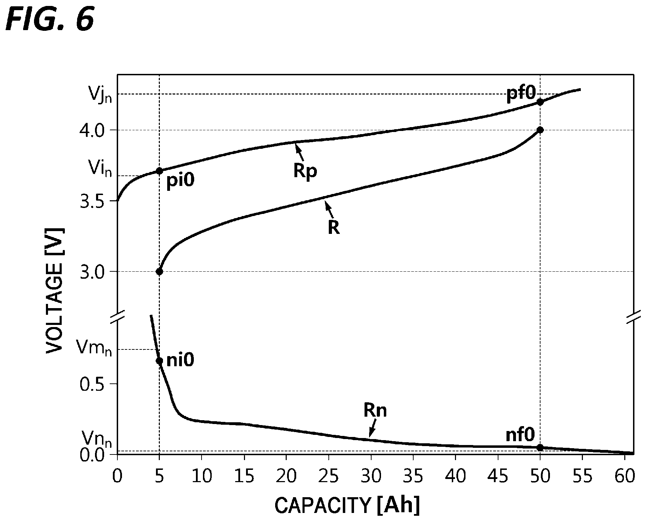

In this regard, an embodiment will be described herein later with reference to FIGS. 6 to 13, in which the control unit 120 adjusts the reference positive electrode profile and the reference negative electrode profile to correspond to the battery profile, thereby determining the adjusted positive electrode profile and the adjusted negative electrode profile of the battery.

The battery information generating apparatus 100 according to an embodiment of the present disclosure may set the positive electrode section and the negative electrode section corresponding to the degradation level of the battery, as an adjustment condition for the reference positive electrode profile and the reference negative electrode profile. For example, since the adjustment condition according to the degradation level of the battery is further set, the positive electrode profile and the negative electrode profile obtained as a result of the adjustment may more accurately reflect the state of the battery. The battery information generating apparatus 100 may accurately estimate the positive electrode profile and the negative electrode profile corresponding to the state of the battery, in consideration of the degradation level of the battery.

Meanwhile, the profile acquisition unit 110 and the control unit 120 provided in the battery information generating apparatus 100 may selectively include, for example, a processor, an application-specific integrated circuit (ASIC), other chipsets, logic circuits, registers, a communication modem, and a data processing apparatus, which are well-known in the art, in order to execute various control logics performed in the present disclosure. When the control logics are implemented by software, the profile acquisition unit 110 and the control unit 120 may be implemented as a set of program modules. In this case, the program modules may be stored in a memory, and executed by the profile acquisition unit 110 and the control unit 120. The memory may be provided inside or outside the profile acquisition unit 110 and the control unit 120, and may be connected to the profile acquisition unit 110 and the control unit 120 by various well-known means.

The battery information generating apparatus 100 may further include the storage unit 130. The storage unit 130 may store, for example, data or programs necessary when each component of the battery information generating apparatus 100 performs the operation and function thereof, or data generated when the operation and function are performed. The storage unit 130 is not particularly limited in type as long as it is a well-known information storage means capable of recording, erasing, updating, and reading data. The information storage means may include, for example, a RAM, a flash memory, a ROM, an EEPROM, and a register. Further, the storage unit 130 may store program codes, in which processes executable by the profile acquisition unit 110 and the control unit 120 are defined.

In another embodiment, the section information for each degradation level may be set for each of a plurality of cycles to include section information in accordance with the degradation level relative to the previous cycle. The control unit 120 may be configured to set the positive electrode section and the negative electrode section that correspond to the cycle and the degradation level of the battery, based on the section information for each degradation level.

For example, the section information for each degradation level may be set further considering the degradation level per cycle of the battery.

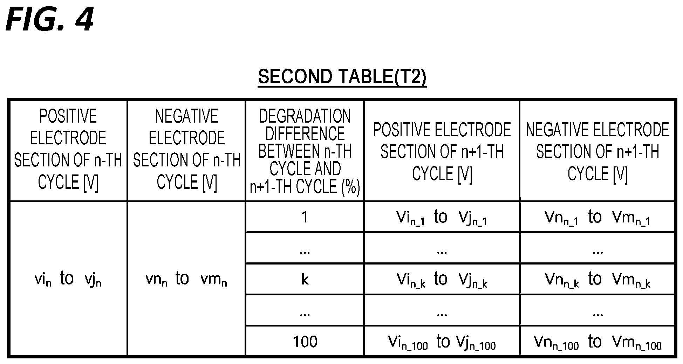

FIG. 4 is a view schematically illustrating a second table T2 representing the section information for each degradation level according to an embodiment of the present disclosure. The second table T2 of FIG. 4 represents the association relationship between the degradation level difference from the previous cycle of the battery and the positive and negative electrode sections. For example, the second table T2 may include information about the positive electrode section and the negative electrode section set for each degradation level difference from the previous cycle.

For example, in the embodiment of FIG. 4, when the degradation level difference between an n-th cycle and an n+1-th cycle is k %, the positive electrode section of the n+1-th cycle may be set to Vi_{n_k} to Vj_{n_k}, and the negative electrode section thereof may be set to Vn_{n_k} to Vm_{n_k}.

For example, by reflecting the degradation level difference "k" in the positive electrode section Viₙ to Vjₙ of the n-th cycle, the positive electrode section Vi_{n_k} to Vj_{n_k} of the n+1-th cycle may be set. Further, by reflecting the degradation level difference "k" in the negative electrode section Viₙ to Vjₙ of the n-th cycle, the negative electrode section Vi_{n_k} to Vj_{n_k} of the n+1-th cycle may be set.

The battery information generating apparatus 100 may adjust the reference positive electrode profile and the reference negative electrode profile under the condition of the positive electrode section and the negative electrode section taking into account the degradation level difference per cycle of the battery. Thus, the positive electrode profile and the negative electrode profile of the battery obtained as a result of the adjustment may more accurately reflect the state of the battery.

In yet another embodiment, the section information for each degradation level may be preset for each of a plurality of cycles to include section information in accordance with the degradation type and the degradation level relative to the previous cycle. Then, the control unit 120 may be configured to set the positive electrode section and the negative electrode section that correspond to the cycle of the battery, the degradation type, and the degradation level, based on the section information for each degradation level.

The section information for each degradation level may be set further considering the degradation level and the degradation type for each cycle of the battery.

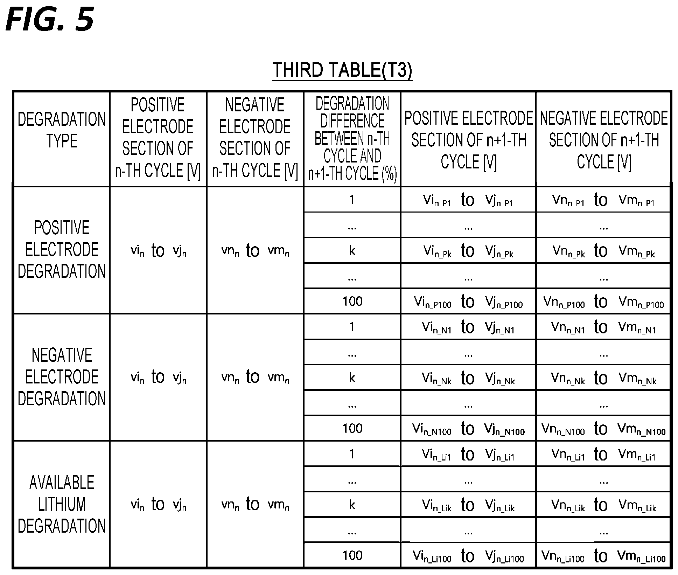

FIG. 5 is a view schematically illustrating a third table T3 representing the section information for each degradation level according to an embodiment of the present disclosure. The third table T3 of FIG. 5 represents the association relationship among the degradation type of the battery, the degradation level difference from the previous cycle, and the positive and negative electrode sections. For example, the third table T3 may include information about the positive electrode section and the negative electrode section that are set in accordance with the degradation level difference from the previous cycle, for each degradation type of the battery.

For example, the degradation type included in the third table T3 refers to the type of degradation of the battery that occurs between the "n-th" cycle and the "n+1-th" cycle. The degradation type may include positive electrode degradation, negative electrode degradation, and available lithium degradation.

Here, the positive electrode degradation refers to the degraded state of the battery with a positive electrode capacity loss. For example, the positive electrode degradation may refer to a state where the positive electrode is physically and/or chemically damaged, and thus, is suffering from a loss of the positive electrode capacity that may participate in the charging and discharging.

Similarly to the positive electrode degradation, the negative electrode degradation refers to the degraded state of the battery with a negative electrode capacity loss. For example, the negative electrode degradation may refer to a state where the negative electrode is physically and/or chemically damaged and is suffering from a loss of the negative electrode capacity that may participate in the charging and discharging.

The available lithium degradation refers to the degraded state of the battery with a loss of available lithium that may participate in the charging and discharging. When the available lithium is lost, the Li-plating phenomenon may occur so that lithium precipitates on the surface of the negative electrode. When lithium precipitates on the surface of the negative electrode, side reactions with the electrolyte may occur, and the kinetic balance of the battery may change, which may cause the degradation of the battery. Further, when a lithium metal precipitates on the surface of the negative electrode, an internal short circuit may occur in the battery, which may lead to, for example, the ignition or explosion caused by the internal short circuit.

For example, in the embodiment of FIG. 5, when the degradation type of the battery is the positive electrode degradation, and the degradation level difference between the n-th cycle and the n+1-th cycle is k %, the positive electrode section of the n+1-th cycle may be set to Vi_{n_Pk} to Vj_{n_Pk}, and the negative electrode section thereof may be set to Vn_{n_Pk} to Vm_{n_Pk}.

For example, by reflecting the degradation type P and the degradation level difference "k" in the positive electrode section Viₙ to Vjₙ of the n-th cycle, the positive electrode section Vi_{n_Pk} to Vj_{n_Pk} of the n+1-th may be set. Further, by reflecting the degradation type P and the degradation level difference "k" in the negative electrode section Viₙ to Vjₙ of the n-th cycle, the negative electrode section Vi_{n_Pk} to Vj_{n_Pk} of the n+1-th cycle may be set.

When multiple types of degradation progress, the positive electrode section and the negative electrode section may be set based on the multiple degradation types and the degradation level difference.

For example, it is assumed that in the n+1-th cycle, a positive electrode degradation P of k % has occurred, and an available lithium degradation Li of k % has occurred.

The initial voltage of the positive electrode section may be Vi_{n_Pk} or Vi_{n_Lik}, and the final voltage of the positive electrode section may be Vj_{n_Pk} or Vj_{n_Lik}. Since the positive electrode section needs to be set conservatively to correspond to the degraded state of the battery, the initial voltage of the positive electrode section may be the greater of Vi_{n_Pk} and Vi_{n_Lik}, and the final voltage of the positive electrode section may be the lesser of Vj_{n_Pk} and Vj_{n_Lik}.

The initial voltage of the negative electrode section may be Vn_{n_Pk} or Vn_{n_Lik}, and the final voltage of the negative electrode section may be Vm_{n_Pk} or Vm_{n_Lik}. Since the negative electrode section needs to be set conservatively to correspond to the degraded state of the battery, the initial voltage of the negative electrode section may be the greater of Vn_{n_Pk} and Vn_{n_Lik}, and the final voltage of the negative electrode section may be the lesser of Vm_{n_Pk} and Vm_{n_Lik}.

For example, the battery information generating apparatus 100 may adjust the reference positive electrode profile and the reference negative electrode profile under the condition of the positive electrode section and the negative electrode section taking into account the degradation level difference per cycle of the battery and the degradation type. Thus, the positive electrode profile and the negative electrode profile of the battery obtained as a result of the adjustment may more accurately reflect the state of the battery.

The control unit 120 may be configured to output the positive electrode profile and the negative electrode profile to the outside, to provide information about the battery.

For example, the control unit 120 may be connected to an external device capable of diagnosing the state of the battery, for a communication via a wired or wireless network. The control unit 120 may transmit the positive electrode profile and/or the negative electrode profile to the external device through a wired and/or wireless communication. For example, the external device is not particularly limited as long as it is a device including a diagnosing device or server and capable of analyzing the positive electrode profile and/or the negative electrode profile to diagnose the state of the battery.

Since the positive electrode profile and the negative electrode profile are strongly presumed to represent the current state of the battery, the state of the battery may be diagnosed based on the positive electrode profile and the negative electrode profile.

The battery information generating apparatus 100 may generate the positive electrode profile and the negative electrode profile used to diagnose the state of the battery, thereby improving the accuracy of the diagnosis of the battery state.

Hereinafter, descriptions are made on an embodiment where the control unit 120 adjusts the reference positive electrode profile and the reference negative electrode profile, with reference to FIGS. 6 to 13.

FIG. 6 is a graph referred-to for describing an example of each of the reference positive electrode profile and the reference negative electrode profile. In the graph of FIG. 6, the horizontal axis (X axis) represents the capacity (Ah), and the vertical axis (Y axis) represents the voltage.

Referring to FIG. 6, the storage unit 130 may store the reference positive electrode profile Rp and the reference negative electrode profile Rn. A reference cell may be a coin-type cell including a positive electrode half cell and a negative electrode half cell, or a three-electrode cell.

The reference positive electrode profile Rp may represent a correspondence between the positive electrode voltage and the capacity of the reference cell. The positive electrode voltage of the reference cell refers to a potential difference between the potential of a reference electrode (not illustrated) and the potential of the positive electrode of the reference cell.

The reference negative electrode profile Rn may represent a correspondence between the negative electrode voltage and the capacity of the reference cell. The negative electrode voltage of the reference cell refers to a potential difference between the potential of the reference electrode and the potential of the negative electrode of the reference cell.

Each of the positive electrode voltage and the negative electrode voltage may be a closed circuit voltage (CCV) or an open circuit voltage (OCV).

In order to acquire the closed circuit voltage of each of the positive electrode and the negative electrode of the reference cell, a first charging protocol or a first discharging protocol may be used. The first charging protocol may be a constant current charging method using a first current rate. The first discharging protocol may be a constant current discharging method using the first current rate. In an example, while the reference cell is charged continuously by the first charging protocol or discharged continuously by the first discharging protocol, the closed circuit voltages of the positive electrode and the negative electrode of the reference cell may be measured periodically or non-periodically and recorded as the positive electrode voltage and the negative electrode voltage of the reference cell, respectively.

In order to acquire the open circuit voltage of each of the positive electrode and the negative electrode of the reference cell, a second charging protocol or a second discharging protocol may be used. The second charging protocol may be an intermittent charging method that alternately performs a constant current charging using a second current rate and a resting. The second discharging protocol may be an intermittent discharging method that alternately performs a constant current discharging using the second current rate and a resting. According to an embodiment, the second current rate (*e.g.,* 3.0 C) may be predetermined to be greater than the first current rate (*e.g.,* 0.05 C).

In an example, each time the charging time by the constant current charging of the second charging protocol elapses by a set time, or the charging capacity of the reference cell increases by a set capacity, the charging of the reference cell may be stopped for a predetermined resting time, and then, the constant current charging may be resumed. The charging capacity may be calculated by periodically or non-periodically accumulating sample values of the charging current by the first charging protocol or the second charging protocol.

In another example, each time the discharging time by the constant current discharging of the second discharging protocol elapses by a set time, or the discharging capacity of the reference cell decreases by a set capacity, the discharging of the reference cell may be stopped for a predetermined resting time, and then, the constant current discharging may be resumed. The discharging capacity may be calculated by periodically or non-periodically accumulating sample values of the discharging current by the first discharging protocol or the second discharging protocol.

In this case, the open circuit voltages of the positive electrode and the negative electrode of the reference cell that are measured at a specific timing for each resting time may be recorded as the positive electrode voltage and the negative voltage of the reference cell.

For the convenience of description, it is assumed that the horizontal axis in FIGS. 6 to 13 represents the charging capacity.

At least one of the reference positive electrode profile Rp and the reference negative electrode profile Rn may be aligned along the horizontal axis, such that a result obtained by synthesizing a portion of the common capacity range of the two profiles Rp and Rn (*e.g.,* 5 Ah to 50 Ah in FIG. 6) matches a reference full-cell profile R. FIG. 6 illustrates a case where the start point of the reference positive electrode profile Rp (the point corresponding to the capacity "0") is set as a reference point, and the reference negative electrode profile Rn is aligned by being shifted to the right side. As a result of the shift, for example, when the reference positive electrode profile Rp and the reference negative electrode profile Rn are synthesized, a profile matching the reference full-cell profile R may be acquired.

From FIG. 6, it may be seen that both ends of the reference positive electrode profile Rp and both ends of the reference negative electrode profile Rn deviate from each other. For example, the capacity range of the reference positive electrode profile Rp and the capacity range of the reference negative electrode profile Rn do not match and only partially overlap with each other. Thus, the reference full-cell profile R represents the full-cell voltage of the reference cell in a portion of the overlapping capacity range between the reference positive electrode profile Rp and the reference negative electrode profile Rn. For example, the reference full-cell profile R is an example of a full-cell voltage profile obtained by directly subtracting a portion of the reference negative electrode profile Rn from a portion of the reference positive electrode profile Rp.

The reference full-cell profile R may represent a correspondence between the capacity and the full-cell voltage of a new battery cell verified to meet quality standards. For example, the reference cell has the same levels of positive electrode performance and negative electrode performance as those of a new battery cell verified to meet quality standards.

The reference full-cell profile R may represent a correspondence between the voltage and the capacity of the reference cell in at least the voltage range of interest (*e.g.,* 3.0 V to 4.0 V). The lower and upper limits of the voltage range of interest may be a first set voltage (3.0 V in FIG. 6) and a second set voltage (4.0 V in FIG. 6).

When the full-cell voltage of a specific battery cell including the reference cell is the same as the first set voltage, the SOC may be set to 0 %. When the full-cell voltage of a specific battery cell including the reference cell is the same as the second set voltage, the SOC may be set to 100 %. According to FIG. 6, the reference cell may reach a fully charged state (SOC 100 %) from a fully discharged state (SOC 0 %) by the charging capacity of 45 Ah.

In the descriptions herein, the positive electrode activation initial point of a specific battery cell on the positive electrode profile represents the positive electrode voltage when the full-cell voltage of the battery cell matches the first set voltage. Further, the negative electrode activation initial point of the battery cell on the negative electrode profile represents the negative electrode voltage when the full-cell voltage of the battery cell matches the first set voltage. Thus, the voltage difference between the positive electrode activation initial point and the negative electrode activation initial point is the same as the first set voltage.

The positive electrode activation final point of a specific battery cell on the positive electrode profile represents the positive electrode voltage when the full-cell voltage of the battery cell matches the second set voltage. Further, the negative electrode activation final point of the battery cell on the negative electrode profile represents the negative electrode voltage when the full-cell voltage of the battery cell matches the second set voltage. Thus, the voltage difference between the positive electrode activation final point and the negative electrode activation final point is the same as the second set voltage.

In the storage unit 130, information may be pre-recorded, which represents the voltage of each of a reference positive electrode activation initial point pi0, a reference positive electrode activation final point pf0, a reference negative electrode activation initial point ni0, and a reference negative electrode activation final point nf0. The reference positive electrode activation initial point pi0 and the reference positive electrode activation final point pf0 are the positive electrode activation initial point and the positive electrode activation final point, respectively, on the reference positive electrode profile Rp. The reference negative electrode activation initial point ni0 and the reference negative electrode activation final point nf0 are the negative electrode activation initial point and the negative electrode activation final point, respectively, on the reference negative electrode profile Rp.

The voltage difference between the reference positive electrode activation initial point pi0 and the reference negative electrode activation initial point ni0 may be equal to the first set voltage (*e.g.,* 3.0 V). The voltage difference between the reference positive electrode activation final point pf0 and the reference negative electrode activation final point nf0 may be equal to the second set voltage (*e.g.,* 4.0 V).

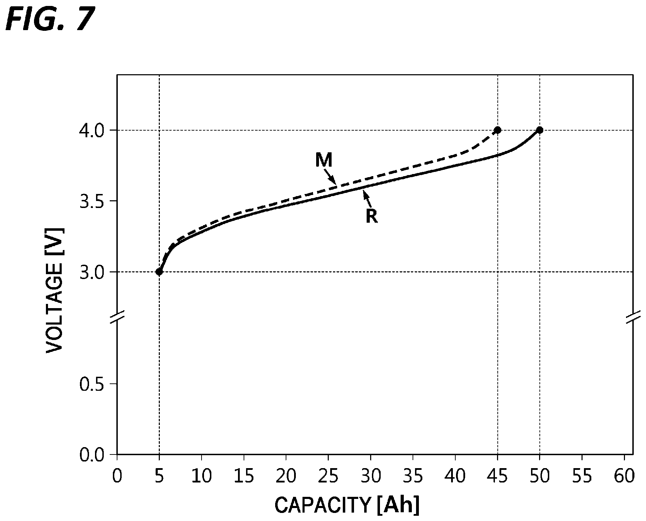

FIG. 7 is a graph referred-to for describing an example of a measured full-cell profile of a target cell. In the graph of FIG. 7, the horizontal axis (X axis) represents the capacity (Ah), and the vertical axis (Y axis) represents the voltage.

Referring to FIG. 7, the control unit 120 may generate a measured full-cell profile M representing a correspondence between the capacity and the terminal voltage (also referred to as the "full-cell voltage") of a battery cell subjected to the diagnosis (also referred to as the "target cell"). Here, the terminal voltage refers to the voltage between both ends of the target cell (CCV or OCV), and is distinct from the positive electrode voltage and the negative electrode voltage described above. For example, the terminal voltage of the target cell may be the difference between the positive electrode voltage and the negative electrode voltage of the target cell.

In order to generate the measured full-cell profile M, the first charging protocol, the first discharging protocol, the second charging protocol, or the second discharging protocol described above may be used. Similarly to the reference full-cell profile R, the measured full-cell profile M may represent a correspondence between the voltage and the capacity of the target cell in at least the voltage range of interest (*e.g.,* 3.0 to 4.0 V).

When the reference positive electrode profile Rp and the reference negative electrode profile Rn are acquired by the first charging protocol (or the first discharging protocol), the measured full-cell profile M may also be generated based on voltage time series and capacity time series collected through a charging procedure (or a discharging procedure) by the first charging protocol (or the first discharging protocol).

When the reference positive electrode profile Rp and the reference negative electrode profile Rn are acquired by the second charging protocol (or the second discharging protocol), the measured full-cell profile M may also be generated based on voltage time series and capacity time series collected through a charging procedure (or a discharging procedure) by the second charging protocol (or the second discharging protocol).

The voltage time series represents a variation of the terminal voltage of the target cell over time. The capacity time series represents a variation of the capacity of the target cell over time while the target cell is being charged or discharged by the first charging protocol, the first discharging protocol, the second charging protocol, or the second discharging protocol.

As compared to the reference full-cell profile R described above with reference to FIG. 6, the measured full-cell profile M may represent an actual correspondence between the capacity of the target cell and the full-cell voltage. The target cell may be a new battery cell requiring a quality verification, or a battery cell that has degraded after the quality verification and is no longer a new battery cell.

Thus, as illustrated in FIG. 7, a certain degree of difference may exist between the measured full-cell profile M and the reference full-cell profile R. For example, the voltage of the measured full-cell profile M is higher than the voltage of the reference full-cell profile R at the same capacity value, which results from, for example, a manufacturing defect of the target cell, a loss of positive electrode capacity, a loss of negative electrode capacity, and/or a loss of available lithium. In general, as the target cell degrades due to the repeated charging and discharging, the difference between the measured full-cell profile M and the reference full-cell profile R increases progressively. According to FIG. 7, unlike the reference cell described above with reference to FIG. 6, the target cell requires a charging capacity of 40 Ah to reach 45 Ah corresponding to the fully charged state (SOC 100 %) from 5 Ah corresponding to the fully discharged state (SOC 0 %), which is 5 Ah less than the charging capacity of 45 Ah required to fully charge the reference cell.

In the embodiments of FIGS. 6 and 7, Ah is used as the unit for the horizontal axis, but the unit of the horizontal axis may be expressed in other forms. For example, instead of Ah, a percentage % representing the state of charge (SOC) may be used as the unit of the horizontal axis.

When the measured full-cell profile M is generated, the control unit 120 may compare the measured full-cell profile M with at least one comparative full-cell profile. The comparative full-cell profile may be a result obtained from adjusting the reference positive electrode profile Rp and the reference negative electrode profile Rn stored in the storage unit 130 to generate an adjusted positive electrode profile and an adjusted negative electrode profile, respectively, and then, synthesizing (combining) the adjusted positive electrode profile and the adjusted negative electrode profile.

For example, when the reference full-cell profile R is a result of subtracting a portion of the reference negative electrode profile Rn from a portion of the reference positive electrode profile Rp, the comparative full-cell profile may be a result of subtracting a portion of the adjusted negative electrode profile from a portion of the adjusted positive electrode profile.

The control unit 120 may directly adjust the reference positive electrode profile Rp and the reference negative electrode profile Rn to generate at least one comparative full-cell profile. Alternatively, the at least one comparative full-cell profile may be acquired in advance based on the reference positive electrode profile Rp and the reference negative electrode profile Rn, and stored in the storage unit 130. In this case, the control unit 120 may access the storage unit 130 to read and acquire the comparative full-cell profile.

The control unit 120 may repeat an adjustment procedure for adjusting each of the reference positive electrode profile Rp and the reference negative electrode profile Rn at multiple levels, and then, synthesizing the adjusted profiles, to generate a plurality of comparative full-cell profiles from the reference positive electrode profile Rp and the reference negative electrode profile Rn. The comparative full-cell profiles may be referred to as "adjusted reference full-cell profiles."

The control unit 120 may identify a comparative full-cell profile having the minimum error with the measured full-cell profile M, among the plurality of comparative full-cell profiles. Then, the control unit 120 may determine the adjusted positive electrode profile and the adjusted negative electrode profile mapped in the identified comparative full-cell profile to be the positive electrode profile and the negative electrode profile of the target cell.

Meanwhile, various methods well-known in the art at the time of filing of the present disclosure may be used to determine an error between two profiles that may be expressed in a two-dimensional coordinate system. For example, an integral value of an absolute value for a region between two profiles or the root mean square error (RMSE) may be used as the error between the two profiles.

According to the configuration of the present disclosure above, various state information about the target cell may be acquired based on the finally determined adjusted positive electrode profile and negative electrode profile. The finally determined adjusted positive electrode profile and negative electrode profile may be those mapped to the comparative full-cell profile mapped to the minimum error. For example, among the plurality of comparative full-cell profiles, a comparative full-cell profile acquired by synthesizing the final determined adjusted positive electrode profile and negative electrode profile may substantially match the measured full-cell profile M in terms of, for example, a shape.

Thus, according to the present disclosure, the positive electrode profile and the negative electrode profile for the target cell may be acquired without disassembling the target cell or without manufacturing the target cell in the form of a three-electrode cell.

According to an embodiment, when the target cell is a new battery cell, it may easily be diagnosed whether a defect occurs in the target cell or which type of defect occurs when the defect occurs, by analyzing the adjusted positive electrode profile and the adjusted negative electrode profile.

When the target cell is a battery cell that is being used after being subjected to the quality verification, the adjusted positive electrode profile and the adjusted negative electrode profile may be used to determine, for example, the degree of degradation of the target cell for each degradation item.

Further, according to an embodiment of the present disclosure, the positive electrode profile and the negative electrode profile of the target cell may be acquired using a simple method. The present disclosure may be implemented even when only one reference positive electrode profile Rp and only one reference negative electrode profile Rn are stored in the storage unit 130. For example, multiple reference positive electrode profiles Rp and/or multiple reference negative electrode profiles Rn may not be stored in the storage unit 130. Thus, the storage unit 130 may not have a high storage capacity, and it is unnecessary to perform a large number of pre-tests required to acquire multiple reference positive electrode profiles Rp and/or multiple reference negative electrode profiles Rn.

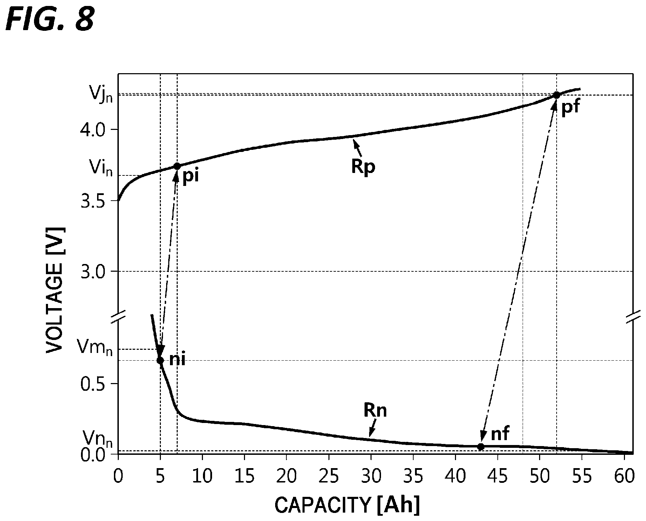

FIGS. 8 to 10 are views referred-to for describing an example of a procedure for generating the comparative full-cell profile used for a comparison with the measured full-cell profile according to an embodiment of the present disclosure.

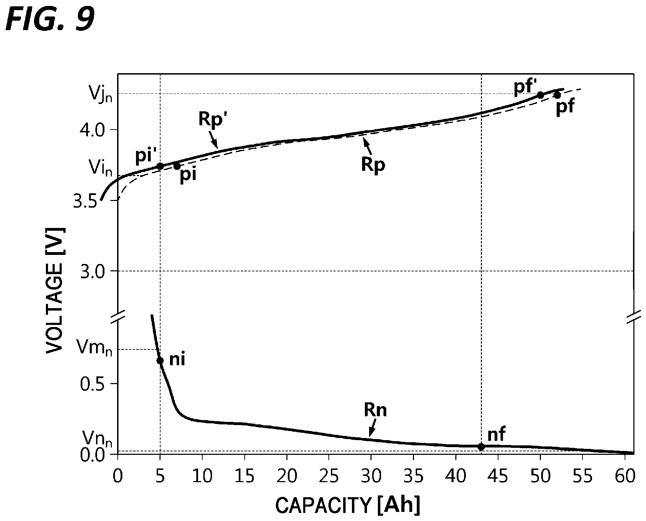

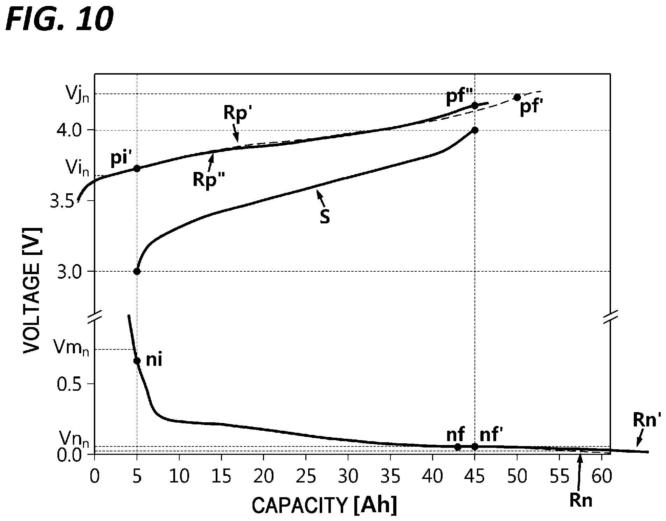

The procedure for generating the comparative full-cell profile, which will be described with reference to FIGS. 8 to 10, is performed in an order of a first routine of setting four points (positive electrode activation initial point, positive electrode activation final point, negative electrode activation initial point, and negative electrode activation final point) to correspond to the voltage range of interest (see FIG. 8), a second routine of performing a profile shift (see FIG. 9), and a third routine of performing a capacity scaling (see FIG. 10). The procedure for generating the comparative full-cell profile according to an embodiment of the present disclosure includes the first and third routines.

First, referring to FIG. 8, the reference positive electrode profile Rp and the reference negative electrode profile Rn are the same as those illustrated in FIG. 6.

The control unit 120 determines a positive electrode activation initial point pi, a positive electrode activation final point pf, a negative electrode activation initial point ni, and a negative electrode activation final point nf on the reference positive electrode profile Rp and the reference negative electrode profile Rn. Here, the control unit 120 determines the positive electrode activation initial point pi and the positive electrode activation final point pf within the positive electrode section Viₙ to Vjₙ, and determines the negative electrode activation initial point ni and the negative electrode activation final point nf within the negative electrode section Vnₙ to Vmₙ.

Either one of the positive electrode activation initial point pi and the negative electrode activation initial point ni depends on the other.

For example, the control unit 120 may divide the positive electrode voltage range from the start point to the end point (or the second set voltage) of the reference positive electrode profile Rp into a plurality of micro-voltage sections, and then, set a boundary point between two adjacent micro-voltage sections among the plurality of micro-voltage sections as the positive electrode activation initial point pi. Each micro-voltage section may have a predetermined size (*e.g.,* 0.01 V). Then, the control unit 120 may set a point on the reference negative electrode profile Rn, which is smaller than the positive electrode activation initial point pi by the first set voltage (*e.g.,* 3 V), as the negative electrode activation initial point ni.

In another example, the control unit 120 may divide the negative electrode voltage range from the start point to the end point of the reference negative electrode profile Rp into a plurality of micro-voltage sections each having a predetermined size, and then, set a boundary point between two adjacent micro-voltage sections among the plurality of micro-voltage sections as the negative electrode activation initial point ni. Then, the control unit 120 may detect a point on the reference positive electrode profile Rp, which is greater than the negative electrode activation initial point ni by the first set voltage, and set the detected point as the positive electrode activation initial point pi.

Either one of the positive electrode activation final point pf and the negative electrode activation final point nf depends on the other.

For example, the control unit 120 may divide the voltage range from the second set voltage to the end point of the reference positive electrode profile Rp into a plurality of micro-voltage sections each having a predetermined size, and then, set a boundary point between two adjacent micro-voltage sections among the plurality of micro-voltage sections as the positive electrode activation final point pf. Then, the control unit 120 may set a point on the reference negative electrode profile Rn, which is smaller than the positive electrode activation final point pf by the second set voltage (*e.g.,* 4 V), as the negative electrode activation final point nf.

In another example, the control unit 120 may divide the negative electrode voltage range from the start point to the end point of the reference negative electrode profile Rn into a plurality of micro-voltage sections each having a predetermined size, and then, set a boundary point between two adjacent micro-voltage sections among the plurality of micro-voltage sections as the negative electrode activation final point nf. Then, the control unit 120 may detect a point on the reference positive electrode profile Rp, which is greater than the negative electrode activation final point nf by the second set voltage, and set the detected point as the positive electrode activation final point pf.

When the determination of the positive electrode activation initial point pi, the positive electrode activation final point pf, the negative electrode activation initial point ni, and the negative electrode activation final point nf is completed, the control unit 120 shifts at least one of the reference positive electrode profile Rp and the reference negative electrode profile Rn to the left or right side along the horizontal axis.

Referring to FIG. 9, the control unit 120 may shift the reference positive electrode profile Rp to the left side (the low capacity side), shift the reference negative electrode profile Rn to the right side (the high capacity side), or shift both the profiles, such that the capacity values of the positive electrode activation initial point pi and the negative electrode activation initial point ni match each other.

Alternatively, the control unit 120 may shift the reference positive electrode profile Rp to the left side, shift the reference negative electrode profile Rn to the right side, or shift both the profiles, such that the capacity values of the positive electrode activation final point pf and the negative electrode activation final point nf match each other.

FIG. 9 illustrates a case where only the reference positive electrode profile Rp is shifted to the left side to generate an adjusted reference positive electrode profile Rp', and as a result, the capacity of the positive electrode activation initial point pi' matches the capacity of the negative electrode activation initial point ni. The adjusted reference positive electrode profile Rp' is a result of performing the adjustment procedure for shifting the reference positive electrode profile Rp to the left side by the difference between the capacities of the positive electrode activation initial point pi and the negative electrode activation initial point ni. Thus, the two positive electrode activation initial points pi and pi' before and after the shift are different from each other only in terms of capacity values and have the same voltage. Further, the two positive electrode activation final points pf and pf' before and after the shift are different from each other only in terms of capacity values and have the same voltage.

When the profiles Rp' and Rn are acquired as a result of the adjustment to shift at least one of the reference positive electrode profile Rp and the reference negative electrode profile Rn, the control unit 120 scales the capacity range of at least one of the acquired profiles Rp' and Rn.

According to the example illustrated in FIG. 9, the control unit 120 further performs an adjustment procedure for contracting or expanding at least one of the adjusted reference positive electrode profile Rp' and the reference negative electrode profile Rn along the horizontal axis.

Referring to FIG. 10, the control unit 120 may contract or expand the adjusted reference positive electrode profile Rp' such that the size of the capacity range between the two points pi' and pf' of the adjusted reference positive electrode profile Rp' matches the size of the capacity range of the measured full-cell profile M, to generate an adjusted reference positive electrode profile Rp". In this case, either one of the two points pi' and pf may be fixed. Therefore, the capacity difference between the two points pi' and pf' of the adjusted reference positive electrode profile Rp" may match the capacity range of the measured full-cell profile M.

The control unit 120 may also contract or expand the reference negative electrode profile Rn such that the size of the capacity range between the two points ni and nf of the reference negative electrode profile Rn matches the size of the capacity range of the measured full-cell profile M, to generate an adjusted reference negative electrode profile Rn'. In this case, either one of the two points ni' and nf' may be fixed. Therefore, the capacity difference between the two points ni and nf of the adjusted reference negative electrode profile Rn' may match the capacity range of the measured full-cell profile M.

In FIG. 10, the adjusted reference positive electrode profile Rp" is a result of contracting the adjusted reference positive electrode profile Rp' illustrated in FIG. 9, and the adjusted reference negative electrode profile Rn' is a result of expanding the reference negative electrode profile Rn illustrated in FIG. 9.

The positive electrode activation final point pf" on the adjusted reference positive electrode profile Rp" corresponds to the positive electrode activation final point pf on the adjusted reference positive electrode profile Rp'. The negative electrode activation final point nf' on the adjusted reference negative electrode profile Rn' corresponds to the negative electrode activation final point nf on the reference negative electrode profile Rn.

The capacity difference between the positive electrode activation initial point pi' and the positive electrode activation final point pf' of the adjusted reference positive electrode profile Rp" matches the size of the capacity range of the measured full-cell profile M. Similarly, the capacity difference between the negative electrode activation initial point ni and the negative electrode activation final point nf of the adjusted reference negative electrode profile Rn' matches the size of the capacity range of the measured full-cell profile M.

Further, the capacity range by the two points pi' and pf' of the adjusted reference positive electrode profile Rp" matches the capacity range by the two points ni and nf of the adjusted reference negative electrode profile Rn'. The control unit 120 may subtract the profile between the two points pi' and pf' of the adjusted reference positive electrode profile Rp" from the profile between the two points ni and nf of the adjusted reference negative electrode profile Rn', to generate a comparative full-cell profile S.

The control unit 120 may calculate an error between the comparative full-cell profile S and the reference full-cell profile R (profile error).

The control unit 120 may mutually map at least two of the adjusted reference positive electrode profile Rp", the adjusted reference negative electrode profile Rn', the positive electrode activation initial point pi', the positive electrode activation final point pf', the negative electrode activation initial point ni, the negative electrode activation final point nf', a first scale factor, a second scale factor, the comparative full-cell profile S, and the profile error, and record the mapped information in the storage unit 130.

The first scale factor may indicate the ratio of the capacity difference between the two points pi' and pf" to the capacity difference between the two points pi0 and pf0. The second scale factor may indicate the ratio of the capacity difference between the two points ni and nf to the capacity difference between the two points ni0 and nf0. For example, the first scale factor is the change ratio of the adjusted reference positive electrode profile Rp" to the reference positive electrode profile Rp, which is a positive electrode change ratio. The second scale factor is the change ratio of the adjusted reference negative electrode profile Rn' to the reference negative electrode profile Rn, which is a negative electrode change ratio.

In the embodiment of FIG. 10, the voltages of the two points pi' and pf' of the adjusted reference positive electrode profile Rp" may be included in the set positive electrode section Viₙ to Vjₙ, and the voltages of the two points ni and nf of the adjusted reference negative electrode profile Rn' may be included in the set negative electrode section Vnₙ to Vmₙ.

Meanwhile, as described above, when the positive electrode voltage range of the reference positive electrode profile Rp is divided into the plurality of micro-voltage sections, the boundary point between two adjacent micro-voltage sections among the plurality of micro-voltage sections may be set as the positive electrode activation initial point pi.

For example, when the positive electrode voltage range of the reference positive electrode profile Rp is divided into 100 micro-voltage sections, 100 boundary points may be set as positive electrode activation initial points pi. Further, when the voltage range equal to or more than the second set voltage in the reference positive electrode profile Rp is divided into 40 micro-voltage sections, 40 boundary points may be set as positive electrode activation final points pf. In this case, up to 4,000 different comparative full-cell profiles S may be generated.

Here, one skilled in the art may readily understand that as the size of the micro-voltage sections decreases, the maximum number of comparative full-cell profiles that may be generated increases, and conversely, as the size of the micro-voltage sections increases, the maximum number of comparative full-cell profiles S that may be generated decreases.

The control unit 120 may identify a minimum value among profile errors between the plurality of comparative full-cell profiles S generated as described above and the reference full-cell profile R, and then, acquire information mapped to the minimum profile error (*e.g.,* at least one of the positive electrode activation initial point, the positive electrode activation final point, the negative electrode activation initial point, the negative electrode activation final point, the first scale factor, and the second scale factor) from the storage unit 130.

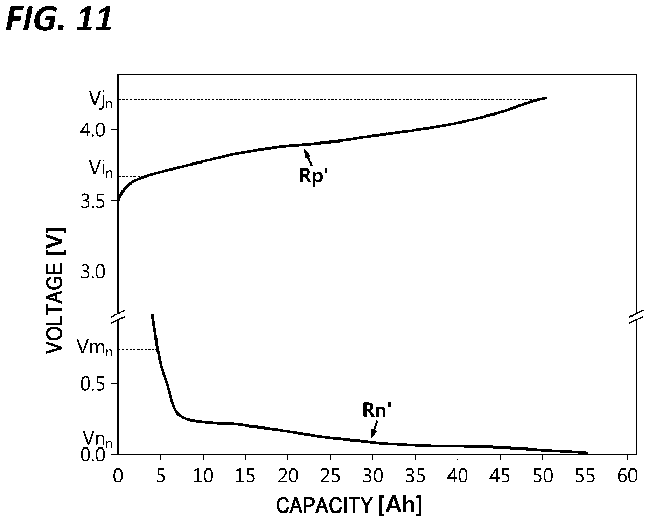

FIGS. 11 to 13 are views referred-to for describing another example of the procedure for generating a comparative full-cell profile U used for a comparison with the measured full-cell profile M according to an embodiment of the present disclosure. The embodiments according to FIGS. 11 to 13 are independent of the embodiments according to FIGS. 8 to 10. Thus, the terms or reference numerals used in common to describe the embodiments of FIGS. 8 to 10 and the embodiments of FIGS. 11 to 13 should be construed as being specific to each embodiment.

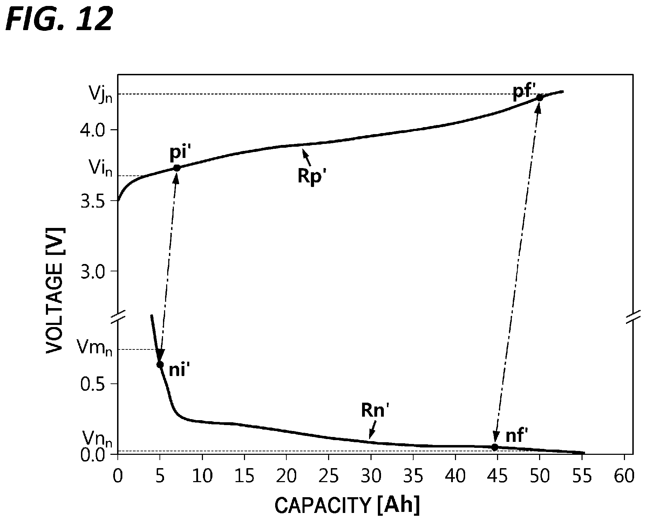

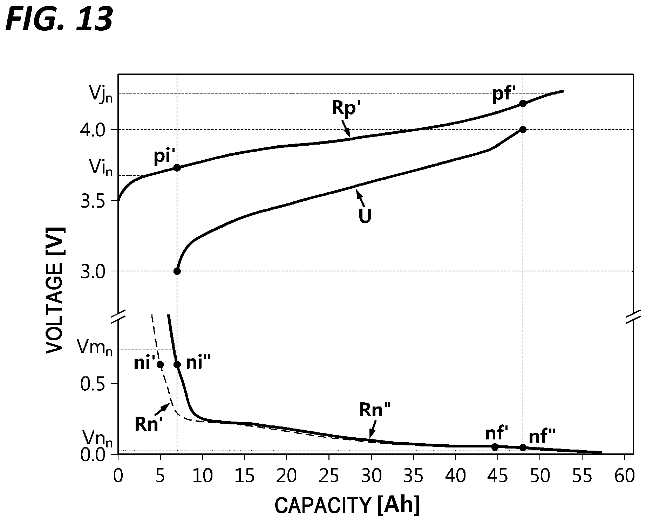

The procedure for generating the comparative full-cell profile U, which will be described with reference to FIGS. 11 to 13, is performed in an order of a fourth routine of performing a capacity scaling (see FIG. 11), a fifth routine of setting the four points (the positive electrode activation initial point, the positive electrode activation final point, the negative electrode activation initial point, and the negative electrode activation final point) (see FIG. 12), and a sixth routine of performing a profile shift (see FIG. 13). The procedure for generating the comparative full-cell profile U according to another embodiment of the present disclosure includes the fourth to sixth routines.

Referring to FIG. 11, the reference positive electrode profile Rp and the reference negative electrode profile Rn are the same as those illustrated in FIG. 6.

The control unit 120 applies the first scale factor and the second scale factor selected from a scaling value range, to the reference positive electrode profile Rp and the reference negative electrode profile Rn, respectively, to generate the adjusted reference positive electrode profile Rp' and the adjusted reference negative electrode profile Rn'.

The scaling value range may be predetermined, or may be variable based on the ratio of the size of the capacity range of the measured full-cell profile M to the size of the capacity range of the reference full-cell profile R. In an example, when the first scale factor and the second scale factor may be selected from the scaling value range (*e.g.,* 90 % to 99 %) consisting of values spaced at 0.1 % intervals (*e*.*g*., 90 %, 90.1 %, 90.2 %, ..., 98.9 %, and 99 %), 91 values may be selected as each of the first scale factor and the second scale factor. In this case, up to 8,281 (91×91) adjusted profile pairs may be generated according to 8,281 (91×91) adjustment levels (combinations of the first scale factor and the second scale factor). Each adjusted profile pair refers to a combination of the adjusted positive electrode profile and the adjusted negative electrode profile.

The adjusted reference positive electrode profile Rp' and the adjusted reference negative electrode profile Rn' illustrated in FIG. 11 represent an example of the result obtained by applying the first scale factor and the second scale factor, each of which is less than 100 %, to the reference positive electrode profile Rp and the reference negative electrode profile Rn.

Since the first scale factor and the second scale factor are each less than 100 %, the adjusted reference positive electrode profile Rp' is a result of contracting the reference positive electrode profile Rp along the horizontal axis, and the adjusted reference negative electrode profile Rn' is also a result of contracting the reference negative electrode profile Rn along the horizontal axis. In order to facilitate the understanding, the present example represents the shape in which the start point of each of the reference positive electrode profile Rp and the reference negative electrode profile Rn is fixed, and the rest thereof is contracted to the left side along the horizontal axis.

In the embodiment above, each scale factor is less than 100 %. However, the scale factor may be equal to or greater than 100 %.

Referring to FIG. 12, the control unit 120 determines the positive electrode activation initial point pi', the positive electrode activation final point pf, the negative electrode activation initial point ni', and the negative electrode activation final point nf based on the adjusted reference positive electrode profile Rp' and the adjusted reference negative electrode profile Rn'.

Either one of the positive electrode activation initial point pi' and the negative electrode activation initial point ni' depends on the other. Either one of the positive electrode activation final point pf' and the negative electrode activation final point nf depends on the other. Further, either one of the positive electrode activation initial point pi' and the positive electrode activation final point pf depends on the other.

When any one of the positive electrode activation initial point pi', the positive electrode activation final point pf, the negative electrode activation initial point ni', and the negative electrode activation final point nf' is set, the remaining three points may be automatically set by the first set voltage, the second set voltage, and/or the size of the capacity range of the measured full-cell profile M (*e.g.,* the charging capacity of SOC 0 % to 100 %).

In an example, the control unit 120 may divide the positive electrode voltage range from the start point to the end point (or the second set voltage) of the adjusted reference positive electrode profile Rp' into a plurality of micro-voltage sections, and then, set a boundary point between two adjacent micro-voltage sections among the plurality of micro-voltage sections as the positive electrode activation initial point pi'. Then, the control unit 120 may set a point on the adjusted reference negative electrode profile Rn, which is smaller than the positive electrode activation initial point pi' by the first set voltage (*e.g.,* 3 V), as the negative electrode activation initial point ni'.

In another example, the control unit 120 may divide the negative electrode voltage range from the start point to the end point of the adjusted reference negative electrode profile Rn' into a plurality of micro-voltage sections each having a predetermined size, and then, set a boundary point between two adjacent micro-voltage sections among the plurality of micro-voltage sections as the negative electrode activation initial point ni'. Then, the control unit 120 may detect a point on the reference positive electrode profile Rp, which is greater than the negative electrode activation initial point ni' by the first set voltage, and set the detected point as the positive electrode activation initial point pi'.

In yet another example, the control unit 120 may divide the voltage range from the second set voltage to the end point of the reference positive electrode profile Rp' into a plurality of micro-voltage sections each having a predetermined size, and then, set a boundary point between two adjacent micro-voltage sections among the plurality of micro-voltage sections as the positive electrode activation final point pf'. Then, the control unit 120 may set a point on the reference negative electrode profile Rn', which is smaller than the positive electrode activation final point pf by the second set voltage (*e.g.,* 4 V), and may set the detected point as the negative electrode activation final point nf.

In still yet another example, the control unit 120 may divide the negative electrode voltage range from the start point to the end point of the adjusted reference negative electrode profile Rn' into a plurality of micro-voltage sections each having a predetermined size, and then, set a boundary point between two adjacent micro-voltage sections among the plurality of micro-voltage sections as the negative electrode activation final point nf'. Then, the control unit 120 may detect a point on the adjusted reference positive electrode profile Rp', which is greater than the negative electrode activation final point nf' by the second set voltage, and set the detected point as the positive electrode activation final point pf.

When any one of the positive electrode activation initial point pi', the positive electrode activation final point pf, the negative electrode activation initial point ni', and the negative electrode activation final point nf is determined, the control unit 120 may further determine the remaining three points based on the determined point.

In an example, when the positive electrode activation initial point pi' is determined first, the control unit 120 may set a point on the adjusted reference positive electrode profile Rp', which has a capacity value greater than the capacity value of the positive electrode activation initial point pi' by the size of the capacity range of the measured full-cell profile M, as the positive electrode activation final point pf'. Further, the control unit 120 may detect a point on the reference negative electrode profile Rn', which is lower than the positive electrode activation initial point pi' by the first set voltage, and set the detected point as the negative electrode activation initial point ni'. Further, the control unit 120 may set a point on the adjusted reference negative electrode profile Rn', which has a capacity value greater than the capacity value of the negative electrode activation initial point ni' by the size of the capacity range of the measured full-cell profile M, as the negative electrode activation final point nf.

In another example, when the positive electrode activation final point pf is determined first, the control unit 120 may set a point on the adjusted reference positive electrode profile Rp', which has a capacity value smaller than the capacity value of the positive electrode activation final point pf by the size of the capacity range of the measured full-cell profile M, as the positive electrode activation initial point pi'. Further, the control unit 120 may detect a point on the reference negative electrode profile Rn', which is lower than the positive electrode activation final point pf by the second set voltage, and set the detected point as the negative electrode activation final point nf. Further, the control unit 120 may set a point on the adjusted reference negative electrode profile Rn', which has a capacity value smaller than the capacity value of the negative electrode activation final point nf by the size of the capacity range of the measured full-cell profile M, as the negative electrode activation initial point ni'.

In yet another example, when the negative electrode activation initial point ni' is determined, the control unit 120 may set a point on the adjusted reference negative electrode profile Rn', which has a capacity value greater than the capacity value of the negative electrode activation initial point ni' by the size of the capacity range of the measured full-cell profile M, as the negative electrode activation final point nf. Further, the control unit 120 may detect a point on the adjusted reference positive electrode profile Rp', which is higher than the negative electrode activation initial point ni' by the first set voltage, and set the detected point as the positive electrode activation initial point pi'. Further, the control unit 120 may set a point on the adjusted reference positive electrode profile Rp', which has a capacity value greater than the capacity value of the positive electrode activation initial point pi' by the size of the capacity range of the measured full-cell profile M, as the positive electrode activation final point pf'.

In still yet another example, when the negative electrode activation final point nf is determined, the control unit 120 may set a point on the adjusted reference negative electrode profile Rn', which has a capacity value smaller than the capacity value of the negative electrode activation final point nf by the size of the capacity range of the measured full-cell profile M, as the negative electrode activation initial point ni'. Further, the control unit 120 may detect a point on the adjusted reference positive electrode profile Rp', which is higher than the negative electrode activation final point nf by the second set voltage, and set the detected point as the positive electrode activation final point pf. Further, the control unit 120 may set a point on the adjusted reference positive electrode profile Rp', which has a capacity value smaller than the capacity value of the positive electrode activation final point pf by the size of the capacity range of the measured full-cell profile M, as the positive electrode activation initial point pi'.

When the determination of the positive electrode activation initial point pi', the positive electrode activation final point pf, the negative electrode activation initial point ni', and the negative electrode activation final point nf is completed based on the pairs of the first scale factor and the second scale factor, the control unit 120 may shift at least one of the adjusted reference positive electrode profile Rp' and the adjusted reference negative electrode profile Rn' to the left or right side along the horizontal axis, to match the capacity values of the positive electrode activation initial point pi' and the negative electrode activation initial point ni' each other, or match the capacity values of the positive electrode activation final point pf and the negative electrode activation final point nf each other.

The adjusted reference negative electrode profile Rn" illustrated in FIG. 13 is acquired by shifting only the adjusted reference negative electrode profile Rn' illustrated in FIG. 12 to the right side. Thus, the capacity values of the positive electrode activation initial point pi' and the negative electrode activation initial point ni" match each other. In this regard, the capacity difference between the positive electrode activation initial point pi' and the positive electrode activation final point pf is the same as the capacity difference between the negative electrode activation initial point ni' and the negative electrode activation final point nf', and therefore, when the capacity values of the positive electrode activation initial point pi' and the negative electrode activation initial point ni" match each other, the capacity values of the positive electrode activation final point pf and the negative electrode activation final point nf also match each other.

Referring to FIG. 13, the control unit 120 may subtract the partial profile between the two points pi' and pf of the adjusted reference positive electrode profile Rp' from the partial profile between the two points ni" and nf' of the adjusted reference negative electrode profile Rn", to generate the comparative full-cell profile S.

The control unit 120 may calculate an error between the comparative full-cell profile U and the reference full-cell profile R (profile error).

The control unit 120 may mutually map at least two of the adjusted reference positive electrode profile Rp', the adjusted reference negative electrode profile Rn', the positive electrode activation initial point pi', the positive electrode activation final point pf, the negative electrode activation initial point ni', the negative electrode activation final point nf', the first scale factor, the second scale factor, the comparative full-cell profile U, and the profile error, and record the mapped information in the storage unit 130.

In the embodiment of FIG. 13, the voltages of the two points pi' and pf of the adjusted reference positive electrode profile Rp' may be included in the set positive electrode section Viₙ to Vjₙ, and the voltages of the two points ni" and nf" of the adjusted reference negative electrode profile Rn" may be included in the set negative electrode section (Vnₙ to Vmₙ).

As described above, the control unit 120 may generate a comparative full-cell profile corresponding to each pair of first scale factor and second scale factor selected from a scaling value range. Since a plurality of pairs of first scale factor and second scale factor exist, it is appreciated that a plurality of comparative full-cell profiles is generated. The control unit 120 may identify a minimum value among profile errors of the plurality of comparative full-cell profiles, and then, acquire information mapped to the minimum profile error from the storage unit 130.

The battery information generating apparatus 100 according to the present disclosure may be applied to a battery management system (BMS). For example, a BMS according to the present disclosure may include the battery information generating apparatus 100 described above. In this configuration, at least a portion of the respective components of the battery information generating apparatus 100 may be implemented by complementing or adding functions of components included in well-known BMSs. For example, the profile acquisition unit 110, the control unit 120, and the storage unit 130 of the battery information generating apparatus 100 may be implemented as components of the BMS.

Further, the battery information generating apparatus 100 according to the present disclosure may be provided in a battery pack. For example, the battery pack according to the present disclosure may include the battery information generating apparatus 100 described above and one or more battery cells. The battery pack may further include, for example, electrical components (*e*.*g*., relays and fuses) and a case.

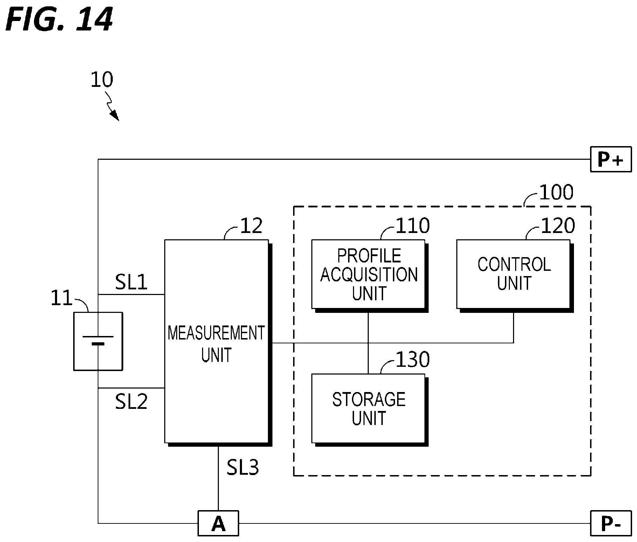

FIG. 14 is a view illustrating an example of the configuration of a battery pack 10 including the battery information generating apparatus 100 according to an embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measurement unit 12 may be connected to a first sensing line SL1, a second sensing line SL2, and a third sensing line SL3. For example, the measurement unit 12 may be connected to the positive electrode terminal of the battery 11 via the first sensing line SL1, and may be connected to the negative electrode terminal of the battery 11 via the second sensing line SL2. The measurement unit 12 may measure the voltage of the battery 11 based on the voltage measured in each of the first sensing line SL1 and the second sensing line SL2.

The measurement unit 12 may be connected to a current measuring unit A via the third sensing line SL3. For example, the current measuring unit A may be an ammeter or a shunt resistor capable of measuring a charging current and a discharging current of the battery 11. The measurement unit 12 may measure the charging current of the battery 11 through the third sensing line SL3 to calculate a charging amount. Further, the measurement unit 12 may measure the discharging current of the battery 11 through the third sensing line SL3 to calculate a discharging amount.

For example, the profile acquisition unit 110 may read or receive battery information about the voltage and the current of the battery from the measurement unit 12. Then, the profile acquisition unit 110 may generate a battery profile based on the battery information.

In another example, the profile acquisition unit 110 may read or receive a battery profile from the measurement unit 12.

An external device may be connected to the positive electrode terminal P+ and the negative electrode terminal P- of the battery pack 10. For example, the external device may be a charging device or a load. The positive electrode terminal of the battery 11, the positive electrode terminal P+ of the battery pack 10, the external device, the negative electrode terminal P- of the battery pack 10, and the negative electrode terminal of the battery 11 may be electrically connected to each other.

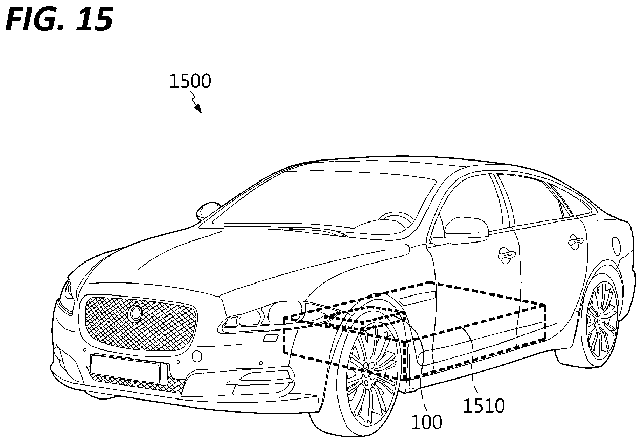

FIG. 15 is a view schematically illustrating a vehicle 1500 according to another embodiment of the present disclosure.

Referring to FIG. 15, a battery pack 1510 according to an embodiment of the present disclosure may be included in the vehicle 1500 such as an electric vehicle (EV) or a hybrid vehicle (HV). The battery pack 1510 may supply a power to a motor via an inverter provided in the vehicle 1500, to drive the vehicle 1500. Here, the battery pack 1510 may include the battery information generating apparatus 100. For example, the vehicle 1500 may include the battery information generating apparatus 100. In this case, the battery information generating apparatus 100 may be an on-board apparatus included in the vehicle 1500.

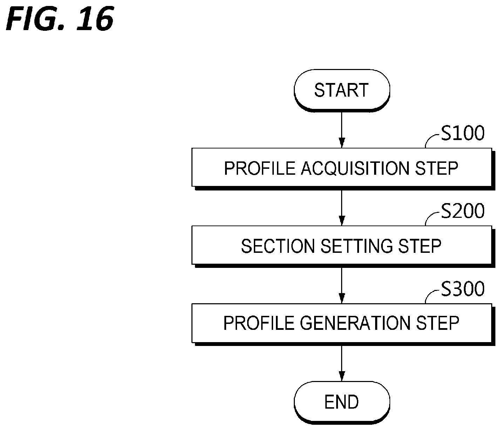

FIG. 16 is a view schematically illustrating a battery information generating method according to a yet another embodiment of the present disclosure.

Referring to FIG. 16, the battery information generating method may include a profile acquisition step S100, a section setting step S200, and a profile generation step S300.

Each step of the battery information generating method may be performed by the battery information generating apparatus 100. Hereinafter, for the convenience of description, descriptions overlapping with the descriptions above are omitted or summarized.

The profile acquisition step S100 is a step of acquiring a battery profile representing a correspondence between the capacity and the voltage of the battery, and may be performed by the profile acquisition unit 110.

For example, the profile acquisition unit 110 may directly read or receive the battery profile from the outside. For example, the profile acquisition unit 110 may acquire the battery profile by being connected to the outside via a wired and/or wireless network to read or receive the battery profile.

In another example, the profile acquisition unit 110 may generate the battery profile based on the battery information about the voltage and the capacity of the battery. For example, the profile acquisition unit 110 may acquire the battery profile by directly generating the battery profile based on the battery information.

The section setting step S200 is a step of setting a positive electrode section and a negative electrode section corresponding to the battery based on the preset section information for each degradation level, and may be performed by the control unit 120.

For example, based on the first table T1 according to the embodiment of FIG. 2, the second table T2 according to the embodiment of FIG. 4, or the third table T3 according to the embodiment of FIG. 5, the control unit 120 may set the positive electrode section and the negative electrode section corresponding to the state of the battery.

The profile generation step S300 is a step of adjusting a positive electrode section of a preset reference positive electrode profile and a negative electrode section of a preset reference negative electrode profile to correspond to the battery profile, to generate a positive electrode profile and a negative electrode profile of the battery, and may be performed by the control unit 120.

For example, the control unit 120 may adjust the reference positive electrode profile and the reference negative electrode profile to generate an adjusted positive electrode profile and an adjusted negative electrode profile.

According to an embodiment, the control unit 120 may adjust the reference positive electrode profile and the reference negative electrode profile, such that the voltage range (or capacity range) of the adjusted positive electrode profile is included in the positive electrode range set in the section setting step S200, and the voltage range (or capacity range) of the adjusted negative electrode profile is included in the negative electrode section set in the section setting step S200.

Then, the control unit 120 may generate a comparative profile from the adjusted positive electrode profile and the adjusted negative electrode profile. The control unit 120 may adjust the reference positive electrode profile and the reference negative electrode profile until the comparative profile corresponds to the battery profile.

The control unit 120 may determine a comparative profile that best corresponds to the battery profile (*e.g*., a comparison profile with the minimum error). Then, the control unit 120 may set the adjusted positive electrode profile corresponding to the determined comparative profile as the positive electrode profile of the battery. Similarly, the control unit 120 may set the adjusted negative electrode profile corresponding to the determined comparative profile as be the negative electrode profile of the battery.

The embodiments of the present disclosure described above are not only implemented by an apparatus and method, but may also be implemented by programs implementing functions corresponding to the components of the embodiments of the present disclosure or a recording medium that stores the programs. This implementation may readily be achieved by one skilled in the art to which the present disclosure belongs, from the descriptions of the embodiments above.

While the present disclosure has been described using limited embodiments and drawings, the present disclosure is not limited thereto, and it may be appreciated that various modifications and changes may be made by those having ordinary skill in the art of the present disclosure within the technical idea of the present disclosure and the equitable scope of the claims set forth below.

Further, since various substitutions, modifications, and changes may be made by those having ordinary skill in the art of the present disclosure within the scope that does not depart from the technical idea of the present disclosure, the present disclosure described above is not limited by the foregoing embodiments and the accompanying drawings, but all or portions of the embodiments may be selectively combined to implement various modifications.

### (Description of Symbols)

10: battery pack
11: battery
12: measurement unit
100: battery information generating apparatus
110: profile acquisition unit
120: control unit
130: storage unit
800: vehicle
810: battery pack

## Claims

1. A battery information generating apparatus comprising:
a profile acquisition unit configured to acquire a battery profile representing a correspondence between a capacity and a voltage of a battery; and
a control unit configured to set a positive electrode section and a negative electrode section that correspond to the battery, based on preset section information for each degradation level, and adjust a preset reference positive electrode profile and a preset reference negative electrode profile to correspond to the battery profile within the positive electrode section and the negative electrode section, to generate a positive electrode profile and a negative electrode profile of the battery.

2. The battery information generating apparatus according to claim 1, wherein the positive electrode section is set to a section including voltages or capacities of a start point and an end point of the positive electrode profile,
the negative electrode section is set to a section including voltages or capacities of a start point and an end point of the negative electrode profile.

3. The battery information generating apparatus according to claim 1, wherein the section information for each degradation level is preset to include section information in accordance with a degradation level of the battery, and
based on the section information for each degradation level, the control unit is configured to set the positive electrode section and the negative electrode section that correspond to the degradation level of the battery.

4. The battery information generating apparatus according to claim 1, wherein the section information for each degradation level is preset to include section information for each of a plurality of cycles in accordance with a degradation level relative to a previous cycle, and
based on the section information for each degradation level, the control unit is configured to set the positive electrode section and the negative electrode section that correspond to the cycle and the degradation level of the battery.

5. The battery information generating apparatus according to claim 1, wherein the section information for each degradation level is preset to include section information for each of a plurality of cycles in accordance with a degradation type and a degradation level relative to a previous cycle, and
based on the section information for each degradation level, the control unit is configured to set the positive electrode section and the negative electrode section that correspond to the cycle, the degradation type, and the degradation level of the battery.

6. The battery information generating apparatus according to claim 1, wherein the control unit is configured to estimate a degradation level of the battery based on a capacity of the battery and a preset initial capacity.

7. The battery information generating apparatus according to claim 1, wherein the control unit is configured to output the positive electrode profile and the negative electrode profile to an outside, to provide information about the battery.

8. A battery pack comprising the battery information generating apparatus according to any one of claims 1 to 7.

9. A vehicle comprising the battery information generating apparatus according to any one of claims 1 to 7.

10. A battery information generating method comprising:
a profile acquisition step of acquiring a battery profile representing a correspondence between a capacity and a voltage of a battery;
a section setting step of setting a positive electrode section and a negative electrode section that correspond to the battery, based on preset section information for each degradation level; and
a profile generation step of adjusting a preset reference positive electrode profile and a preset reference negative electrode profile to correspond to the battery profile within the positive electrode section and the negative electrode section, to generate a positive electrode profile and a negative electrode profile of the battery.

11. The battery information generating method according to claim 10, wherein the section information for each degradation level is preset to include section information in accordance with a degradation level of the battery, and
based on the section information for each degradation level, the section setting step sets the positive electrode section and the negative electrode section that correspond to the degradation level of the battery.

12. The battery information generating method according to claim 10, wherein the section information for each degradation level is preset to include section information for each of a plurality of cycles in accordance with a degradation level relative to a previous cycle, and
based on the section information for each degradation level, the section setting step sets the positive electrode section and the negative electrode section that correspond to the cycle and the degradation level of the battery.

13. The battery information generating method according to claim 10, wherein the section information for each degradation level is preset to include section information for each of a plurality of cycles in accordance with a degradation type and a degradation level relative to a previous cycle, and
based on the section information for each degradation level, the section setting step sets the positive electrode section and the negative electrode section that correspond to the cycle, the degradation type, and the degradation level of the battery.

14. A non-transitory computer-readable storage medium having stored therein a program for performing a battery information generating method, the method comprising:
a profile acquisition step of acquiring a battery profile representing a correspondence between a capacity and a voltage of a battery;
a section setting step of setting a positive electrode section and a negative electrode section that correspond to the battery, based on preset section information for each degradation level; and
a profile generation step of adjusting a preset reference positive electrode profile and a preset reference negative electrode profile to correspond to the battery profile within the positive electrode section and the negative electrode section, to generate a positive electrode profile and a negative electrode profile of the battery.
